# EUROPEAN PATENT APPLICATION

(11) **EP 4 819 797 A2**
(43) Date of publication of application: **07.10.2026**
(21) Application number: 26199969.2
(22) Date of filing: 20.08.2026
(51) Int. Cl.: H10F 10/166

(54) **BACK CONTACT SOLAR CELL AND METHOD FOR MANUFACTURING SAME, PHOTOVOLTAIC MODULE**

(30) Priority: 29.06.2026 CN 202610954740
(71) Applicant: Zhejiang Jinko Solar Co., Ltd., Haining, Zhejiang 314416 (CN)
(72) Inventor: LI, Huimin, Haining, Zhejiang 314416 (CN); DUAN, Weiyuan, Haining, Zhejiang 314416 (CN)
(74) Representative: Schwarz & Partner Patentanwälte GmbH

(57) **Abstract**

The present application provides a back contact solar cell, a method for manufacturing the same, and a photovoltaic module. The back contact solar cell includes a substrate (110) having a first surface (m1) including a first region (m11) and a second region m(12) arranged alternately, a first passivation contact structure (120) disposed on the first region (m11), and a second passivation contact structure (130). The second region (m12) is provided with a pyramid-shaped texture structure. The second passivation contact structure (130) is disposed at least on the second region and covers the pyramid-shaped texture structure, and includes amorphous silicon and nanocrystalline silicon. The second region (130) includes a middle region (m121) and edge regions (m122) located on two sides of the middle region. A thickness difference of a portion of the second passivation contact structure located on the middle region (m121) is greater than a thickness difference of portions of the second passivation contact structure located on the edge regions (m122).

## Description

### TECHNICAL FIELD

The present application relates to the field of solar cell technology, and in particular, to a back contact solar cell and a method for manufacturing the same, and a photovoltaic module.

### BACKGROUND

A back contact (BC) solar cell is a device that converts solar energy into electrical energy. Specifically, all electrodes of the back contact solar cell are disposed on a back side of the cell, and carriers can be generated through the photovoltaic effect and extracted via the electrodes. However, the performance of the back contact solar cell needs to be further improved.

### SUMMARY

In view of this, there is a need to provide a back contact solar cell, a method for manufacturing the same, and a photovoltaic module, so as to improve the performance of the back contact solar cell.

According to an aspect of the present application, an embodiment of the present application provides a back contact solar cell, including a substrate, a first passivation contact structure, and a second passivation contact structure. The substrate has a first surface, the first surface includes a first region and a second region arranged alternately, and the second region is provided with a pyramid-shaped texture structure. The first passivation contact structure is disposed on the first region. The second passivation contact structure is disposed at least on the second region and covers the pyramid-shaped texture structure. The second passivation contact structure is made of a material including amorphous silicon and nanocrystalline silicon. The second region includes a middle region and edge regions located on two sides of the middle region along an arrangement direction of the first region and the second region. A thickness difference of a portion of the second passivation contact structure located on the middle region is greater than a thickness difference of portions of the second passivation contact structure located on the edge regions.

In some embodiments, a portion of the second passivation contact structure located on a top region of the pyramid-shaped texture structure includes nanocrystalline silicon.

In some embodiments, in a direction from the top region of the pyramid-shaped texture structure to a base region of the pyramid-shaped texture structure, a projected area of the top region of the pyramid-shaped texture structure is S1, a projected area of the pyramid-shaped texture structure is S2, and 0.01 ≤ S1/S2 ≤ 0.6.

In some embodiments, 0.05 ≤ S1/S2 ≤ 0.15.

In some embodiments, in a direction from a top region of the pyramid-shaped texture structure to a base region of the pyramid-shaped texture structure, a crystallinity of the second passivation contact structure decreases.

In some embodiments, a grain size of the nanocrystalline silicon is H, and 10 nm ≤ H ≤ 300 nm.

In some embodiments, in the arrangement direction of the first region and the second region, a dimension of the middle region is D1, a dimension of the second region is D2, and 0.5 ≤ D1/D2 ≤ 0.9.

In some embodiments, the thickness difference of the portion of the second passivation contact structure located on the middle region is Δd1, the thickness difference of the portions of the second passivation contact structure located on the edge regions is Δd2, and 2 nm ≤ Δd1 - Δd2 ≤ 20 nm.

In some embodiments, the thickness difference of the portion of the second passivation contact structure located on the middle region is from 1 nm to 35 nm.

In some embodiments, a thickness difference of a portion of the second passivation contact structure located on the middle region and on a top region of the pyramid-shaped texture structure is greater than the thickness difference of the portions of the second passivation contact structure located on the edge regions.

In some embodiments, the second passivation contact structure includes an amorphous material layer and a first doped layer, the amorphous material layer is disposed on the substrate, and the first doped layer is disposed on a side of the amorphous material layer facing away from the substrate. A thickness difference of a portion of the amorphous material layer located on the middle region and on the top region of the pyramid-shaped texture structure is greater than a thickness difference of portions of the amorphous material layer located on the edge regions.

In some embodiments, a thickness difference of a portion of the second passivation contact structure located on the middle region and on a base region of the pyramid-shaped texture structure is greater than the thickness difference of the portions of the second passivation contact structure located on the edge regions.

In some embodiments, the second passivation contact structure includes an amorphous material layer and a first doped layer, the amorphous material layer is disposed on the substrate, and the first doped layer is disposed on a side of the amorphous material layer facing away from the substrate. A thickness difference of a portion of the amorphous material layer located on the middle region and on the base region of the pyramid-shaped texture structure is greater than a thickness difference of portions of the amorphous material layer located on the edge regions.

In some embodiments, a thickness difference of a portion of the second passivation contact structure located on the middle region and on a top region of the pyramid-shaped texture structure is greater than a thickness difference of a portion of the second passivation contact structure located on the middle region and on a base region of the pyramid-shaped texture structure.

In some embodiments, the second passivation contact structure includes an amorphous material layer and a first doped layer, the amorphous material layer is disposed on the substrate, and the first doped layer is disposed on a side of the amorphous material layer facing away from the substrate. A thickness difference of a portion of the amorphous material layer located on the middle region and on the top region of the pyramid-shaped texture structure is greater than a thickness difference of a portion of the amorphous material layer located on the middle region and on the base region of the pyramid-shaped texture structure

In some embodiments, an end of the top region of the pyramid-shaped texture structure facing away from a base region of the pyramid-shaped texture structure has a rounded shape.

In some embodiments, an end of the top region of the pyramid-shaped texture structure facing away from a base region of the pyramid-shaped texture structure has a platform-shaped structure.

According to another aspect of the present application, an embodiment of the present application provides a method for manufacturing the back contact solar cell according to any one of the above embodiments, including: providing a back contact solar cell intermediate, wherein the back contact solar cell intermediate including the substrate, the first passivation contact structure, and an initial second passivation contact structure; and processing the middle region of the second region of the substrate by a laser process, so as to form nanocrystalline silicon in the initial second passivation contact structure, and to cause a thickness difference of a portion the initial second passivation contact structure located on the middle region to be greater than a thickness difference of portions of the initial second passivation contact structure located on the edge regions, thereby forming the second passivation contact structure.

In some embodiments, parameters of the laser process satisfy at least one of the following conditions: the laser is a green nanosecond laser; an energy density of a laser spot is from 20 mJ/cm² to 200 mJ/cm²; and adjacent laser spots are arranged tangentially to each other or in an overlapping manner.

According to yet another aspect of the present application, an embodiment of the present application provides a photovoltaic module, including: the back contact solar cell according to any one of the above embodiments; or the back contact solar cell manufactured by the method for manufacturing the back contact solar cell according to any one of the above embodiments.

In the above back contact solar cell, the method for manufacturing the same, and the photovoltaic module, the back-contact solar cell includes at least the substrate, the first passivation contact structure, and the second passivation contact structure. The pyramid-shaped textured structure is provided on the second region of the substrate, and the second passivation contact structure is disposed at least on the second region and covers the pyramid-shaped textured structure. By configuring the material of the second passivation contact structure to include amorphous silicon and nanocrystalline silicon, the amorphous silicon can be utilized to improve the passivation effect of the second passivation contact structure, while the nanocrystalline silicon can be utilized to reduce the conductive resistance of the second passivation contact structure, thereby reducing the contact resistance between the second passivation contact structure and other conductive components. By configuring the thickness difference of the portion of the second passivation contact structure located on the middle region to be greater than the thickness difference of the portions of the second passivation contact structure located on the edge regions, the locally thinner portion of the second passivation contact structure improves the tunneling probability of carriers, while the locally thicker portion of the second passivation contact structure provides a certain degree of passivation performance. Accordingly, the contact resistance can be reduced while a certain degree of passivation performance is provided. In addition, the portions of the second passivation contact structure located on the edge regions can be utilized to improve the passivation effect at the edges or at interfaces with the first region, thereby reducing the risk of electrical leakage at edges and the recombination current and facilitating an increase in open-circuit voltage. Thus, through mutual cooperation of the amorphous silicon and the nanocrystalline silicon, and through mutual cooperation of the thickness difference of the portion of the second passivation contact structure located on the middle region and the thickness difference of the portions of the second passivation contact structure located on the edge regions, the contact resistance between the second passivation contact structure and other conductive components can be reduced while passivation performance is improved, thereby improving the overall performance of the back contact solar cell.

Additional aspects and advantages of the embodiments of the present application will be set forth in part in the following description, and in part will become apparent from the following description, or may be learned through practice of the embodiments of the present application.

### BRIEF DESCRIPTION OF THE DRAWINGS

Various other advantages and benefits will become apparent to those of ordinary skill in the art upon reading the following detailed description of embodiments. The accompanying drawings are merely used for illustrating the embodiments but are not to be considered as limitations to the present application. In addition, in all the accompanying drawings, the same components are indicated by the same reference numerals. In the accompanying drawings:
FIG. 1 is a partial schematic cross-sectional structural view of a back contact solar cell according to some embodiments of the present application;
FIG. 2 is a schematic structural view of a second passivation contact structure of the back contact solar cell according to some embodiments of the present application;
FIG. 3 is a side-view SEM image of a portion of the back contact solar cell according to some embodiments of the present application;
FIG. 4 is another side-view SEM image of a portion of the back contact solar cell according to some embodiments of the present application;
FIG. 5 is yet another side-view SEM image of a portion of the back contact solar cell according to some embodiments of the present application;
FIG. 6 is a schematic view of a second region according to some embodiments of the present application;
FIG. 7 is a schematic perspective structural view of a pyramid-shaped texture structure according to some embodiments of the present application;
FIG. 8 is a schematic projection view of the pyramid-shaped texture structure according to some embodiments of the present application;
FIG. 9 is a partial schematic structural view of a second passivation contact structure in cooperation with the pyramid-shaped texture structure according to some embodiments of the present application;
FIG. 10 is a schematic view of the pyramid-shaped texture structure according to other embodiments of the present application;
FIG. 11 is a schematic view of the pyramid-shaped texture structure according to still other embodiments of the present application;
FIG. 12 is a partial schematic structural view of the second passivation contact structure in cooperation with the pyramid-shaped texture structure according to other embodiments of the present application;
FIG. 13 is a schematic structural view of a photovoltaic module according to some embodiments of the present application.

### DETAILED DESCRIPTION

In the description of the present application, it should be understood that when the terms such as "center", "longitudinal", "transverse", "length", "width", "thickness", "upper", "lower", "front", "back", "left", "right", "vertical", "horizontal", "top", "bottom", "inside", "outside", "clockwise", "anticlockwise", "axial direction", "radial direction", and "circumferential direction" appear, orientation or position relationships indicated by these terms are based on orientation or position relationships shown in the accompanying drawings, and are intended to facilitate the description of the present application and simplify the description only, rather than indicate or imply that the mentioned apparatus or element must have a particular orientation or must be constructed and operated in a particular orientation. Therefore, such terms should not be construed as limiting the present application.

In addition, if the terms "first" and "second" appear, these terms are used merely for the purpose of description, and should not be construed as indicating or implying relative importance or implying a quantity of indicated technical features. Therefore, features defined with "first" and "second" may explicitly or implicitly include at least one of such features. In the description of the present application, if the term "a plurality of" appears, "a plurality of" means at least two, such as two or three, unless otherwise explicitly limited.

In the present application, unless otherwise explicitly specified or defined, the terms "mount," "connect," "connection," and "fix," if used, shall be understood in a broad sense. For example, it may be a fixed connection, a detachable connection, or an integral connection; may be a mechanical connection or an electrical connection; and may be a direct connection, or an indirect connection through an intermediate medium; it may be communication between the interiors of two elements, or an interaction between two elements, unless otherwise expressly defined. It should be noted that, in the following description and the appended claims, the "electrical connection" between one feature and another feature includes not only direct contact between the one feature and the other feature to form a channel for electrical energy transmission or current transfer, but also the presence of one or more intermediate features between the one feature and the other feature, through which the one feature, the other feature, and the intermediate feature(s) therebetween together form a channel for electrical energy transmission or current transfer so as to achieve electrical energy transmission or current transfer. Those skilled in the art should understand the specific meanings of the foregoing terms in the present application according to specific circumstances.

In the present application, unless otherwise explicitly specified and limited, if descriptions such as a first feature being "on" or "below" a second feature appear, it may mean that the first feature and the second feature are in direct contact, or that the first feature and the second feature are in indirect contact through an intermediary medium. Moreover, the first feature being "over", "above", and "on" the second feature may be the first feature being over or above the second feature, or merely means that the first feature is at a higher horizontal level than the second feature. The first feature being "under", "below", and "underneath" the second feature may be the first feature being under or below the second feature, or merely indicates that the first feature is at a lower horizontal level than the second feature.

It should be noted that, when an element is referred to as being "fixed to" or "disposed on" another element, the element may be directly fixed to or directly disposed on the other element, or an intermediate element may be present therebetween. When an element is referred to as being "connected to" another element, the element may be directly connected to the other element, or an intermediate element may be present therebetween. If present, the terms "vertical," "horizontal," "upper," "lower," "left," "right," and similar expressions used in the present application are for illustrative purposes only and do not limit the present application.

In the accompanying drawings, for clarity, the thicknesses of layers, films, regions, substrates, and the like may be exaggerated. Throughout the specification, the same reference numerals denote the same elements. It should be understood that, when an element such as a layer, a film, a region, or a substrate is referred to as being "on" another element, the element may be directly on the other element, or an intermediate element may be present therebetween. Conversely, when an element is referred to as being "directly on" another element, no intermediate element is present therebetween.

In addition, the embodiments of the present application are described with reference to sectional views as schematic views of some embodiments of the present application, and variations in the shapes shown due to, for example, manufacturing techniques and/or tolerances are anticipated. Therefore, the embodiments of the present application should not be limited to the specific shapes of the regions shown herein, but include deviations in shapes due to, for example, manufacturing techniques, etc.

Moreover, in the description of the embodiments of the present application, terms such as "same," "equal," or "consistent" used with respect to dimensions do not require absolute mathematical or geometric precision. In view of factors such as actual manufacturing, measurement, and materials, it is understood by a person skilled in the art that the above-mentioned terms concerning dimensions include deviations within allowable ranges, or unavoidable deviations. Such deviations should be considered as falling within the meaning of "same in size" as described in the embodiments of the present application, as long as they do not affect the function of the corresponding dimensions in the present application and the realization of technical effects.

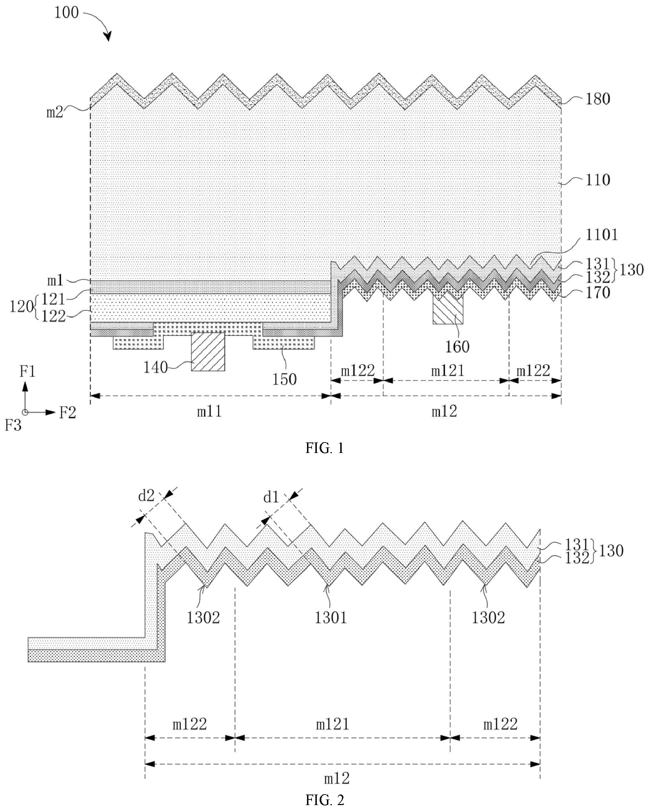

Referring to FIG. 1, FIG. 1 is a partial schematic cross-sectional structural view of a back contact solar cell 100 according to some embodiments of the present application. The embodiments of the present application provide a back contact solar cell 100, including a substrate 110, a first passivation contact structure 120, and a second passivation contact structure 130.

The substrate 110 is configured to receive incident light and generate photogenerated carriers. The substrate 110 can be selected according to actual needs. Exemplarily, the substrate 110 may be a silicon substrate which may include one or more of monocrystalline silicon, polycrystalline silicon, amorphous silicon, or microcrystalline silicon. The doping type of the substrate 110 is not particularly limited. For example, the substrate 110 may be an N-type doped silicon substrate, or may be a P-type doped silicon substrate, with no particular limitation thereon. N-type doping elements may be Group V elements such as phosphorus (P), bismuth (Bi), antimony (Sb), or arsenic (As). P-type doping elements may be Group III elements such as boron (B), aluminum (Al), gallium (Ga), or indium (In). In the embodiments of the present application, the substrate 110 may be an N-type monocrystalline silicon wafer, which may improve the conversion efficiency of the back contact solar cell 100 and reduce manufacturing costs.

The substrate 110 has a first surface m1, and the first surface m1 includes first regions m11 and second regions m12 that are alternately arranged.

Exemplarily, referring to FIG. 1, the substrate 110 has a first surface m1 and a second surface m2 opposite to each other. The first surface m1 and the second surface m2 are arranged opposite to each other along a thickness direction of the substrate 110. The thickness direction of the substrate 110 is a first direction F1 schematically illustrated in FIG. 1. Exemplarily, taking FIG. 1 as an example, the first surface m1 serves as a rear surface, and the second surface m2 serves as a light-receiving surface. It should be understood that the light-receiving surface and the rear surface are defined relative to each other. Specifically, the light-receiving surface refers to a surface of the substrate that is primarily irradiated with sunlight in the back contact solar cell 100 or in a photovoltaic module. The light-receiving surface is generally provided with a surface structure, which may increase a light absorption area and a photogenerated current, thereby helping improve the efficiency of the solar cell.

The first regions m11 and the second regions m12 are alternately arranged. That is, along an arrangement direction of the first regions m11 and the second regions m12, an arrangement of "a first region m11, a second region m12, a first region m11, a second region m12, a first region m11..." is formed, or an arrangement of "a second region m12, a first region m11, a second region m12, a first region m11..." is formed. In other words, along the arrangement direction of the first regions m11 and the second regions m12, each region adjacent to a first region m11 is a second region m12 rather than another first region m11, and each region adjacent to a second region m12 is a first region m11 rather than another second region m12. It should be understood that, along the arrangement direction of the first regions m11 and the second regions m12, the first region in the arrangement may be either a first region m11 or a second region m12, and the last region in the arrangement may also be either the first region m11 or the second region m12, without being specifically limited herein. Exemplarily, taking FIG. 1 as an example, the arrangement direction of the first regions m11 and the second regions m12 is a second direction F2. It should be noted that only one first region m11 and one second region m12 are schematically illustrated in FIG. 1, which is not intended to limit the respective number of the first regions m11 and the second regions m12.

A pyramid-shaped texture structure 1101 is provided on the second region m12. The pyramid-shaped texture structure 1101 has an approximately pyramidal shape. Exemplarily, the pyramid-shaped texture structure 1101 may have a size on the micrometer scale. The pyramid-shaped texture structure 1101 may be formed by a process such as chemical etching or laser etching. By providing the pyramid-shaped texture structure 1101, the reflectivity of the second region m12 can be reduced, thereby reducing optical loss, improving light utilization, and further improving photoelectric conversion efficiency of the back contact solar cell 100.

The first passivation contact structure 120 is provided on the first region m11. The second passivation contact structure 130 is provided at least on the second region m12 and covers the pyramid-shaped texture structure 1101.

The first passivation contact structure 120 and the second passivation contact structure 130 are configured to achieve interface passivation and carrier transport. The first passivation contact structure 120 contains a first doping element. The second passivation contact structure 130 contains a second doping element. The doping type of the first doping element is different from that of the second doping element, and the doping type of the second doping element may be the same as that of a doping element of the substrate 110. Exemplarily, the substrate 110 may be an N-type substrate 110, the first doping element may be a P-type element, and the second doping element may be a N-type element.

The second passivation contact structure 130 is provided at least on the second region m12. That is, the second passivation contact structure 130 may be provided entirely on the second region m12, or a portion of the second passivation contact structure 130 may be provided on the second region m12 while another portion of the second passivation contact structure 130 is provided on the first region m11. Exemplarily, taking FIG. 1 as an example and referring to FIG. 2 in conjunction, FIG. 2 is a schematic structural view of the second passivation contact structure 130 of the back contact solar cell 100 according to some embodiments of the present application. FIG. 2 schematically illustrates that a portion of the second passivation contact structure 130 is provided on the second region m12, and another portion of the second passivation contact structure 130 is provided on a side of the first passivation contact structure 120 facing away from the substrate 110.

In some embodiments, the first passivation contact structure 120 may be composed of a tunneling dielectric layer (for example, a thin silicon oxide layer or a thin silicon oxynitride layer) and a conductive passivation layer located on a surface of the tunneling dielectric layer. The conductive passivation layer may be made of a material including, but not limited to, doped microcrystalline silicon, doped polycrystalline silicon, or doped silicon carbide.

In some embodiments, the second passivation contact structure 130 may be composed of an amorphous material layer and a conductive passivation layer located on a surface of the amorphous material layer. For example, the amorphous material layer may be an intrinsic amorphous silicon layer, an intrinsic microcrystalline silicon layer, an intrinsic silicon oxide layer, or the like. The material of the conductive passivation layer of the second passivation contact structure 130 may be understood with reference to the material of the conductive passivation layer of the first passivation contact structure 120, and details are not described herein again. The conductive passivation layer of the first passivation contact structure 120 and the conductive passivation layer of the second passivation contact structure 130 contain doping elements of different doping types.

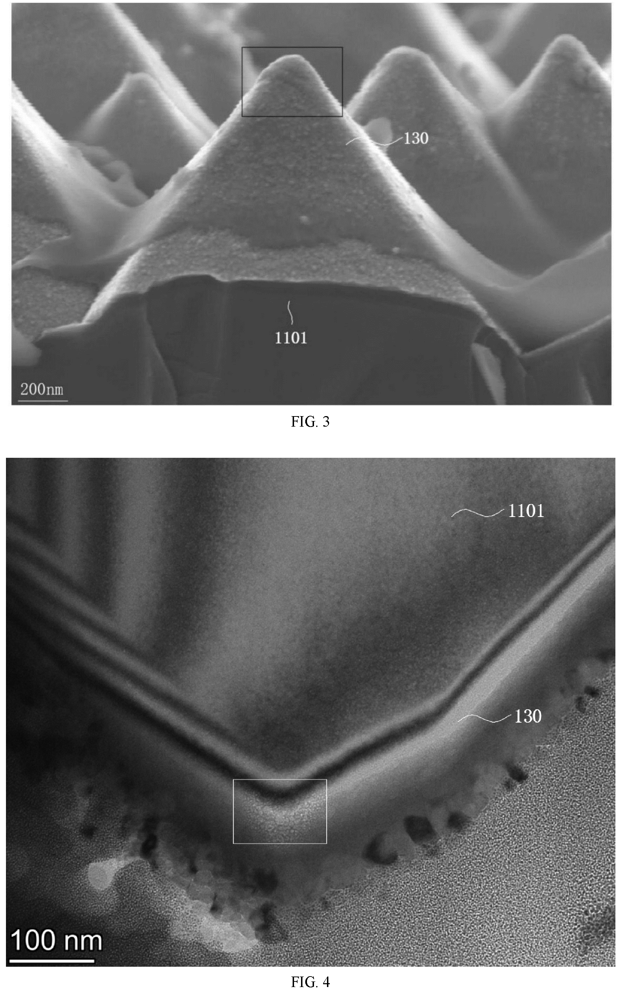

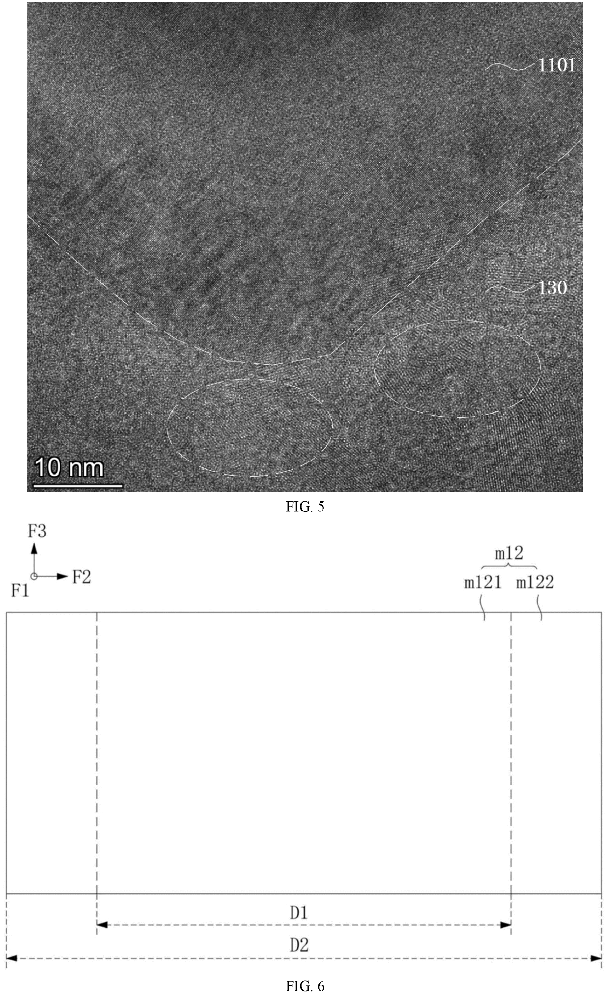

In some embodiments, the second passivation contact structure 130 is made of a material including amorphous silicon and nanocrystalline silicon. Amorphous silicon refers to a structure in which silicon atoms do not form a crystal lattice and are in a grain-free state. Nanocrystalline silicon refers to a structure in which silicon atoms form a crystal lattice and are in a state having nanometer-scale grains. Referring to FIG. 3 to FIG. 5 in conjunction, FIG. 3 is a side-view scanning electron microscope (SEM) image of a portion of the back contact solar cell 100 according to some embodiments of the present application, FIG. 4 is another side-view SEM image of a portion of the back contact solar cell 100 according to some embodiments of the present application, and FIG. 5 is yet another side-view SEM image of a portion of the back contact solar cell 100 according to some embodiments of the present application. It can be seen that the second passivation contact structure 130 is made of a material including amorphous silicon and nanocrystalline silicon. In FIG. 3 and FIG. 4, rectangular boxes schematically indicate regions in which nanocrystalline silicon can be observed. The image shown in FIG. 5 is an enlarged view of the structure within the rectangular box in FIG. 4. In FIG. 5, a dashed line indicates a boundary between the pyramid-shaped textured structure 1101 and the second passivation contact structure 130, and elliptical boxes schematically indicate regions in which nanocrystalline silicon is present. It should be understood that these boxes are merely used to indicate the locations of the corresponding regions and are not intended to limit the structures. Respective scale bars are shown in FIGS. 3 to 5.

Referring to FIG. 6, FIG. 6 is a schematic view of the second region m12 according to some embodiments of the present application. The second region m12 includes a middle region m121 and edge regions m122 located on two sides of the middle region m121 along the arrangement direction of the first regions m11 and the second regions m12. That is, with reference to the arrangement direction of the first regions m11 and the second regions m12, the second region m12 is divided into the middle region m121 and the edge regions m122. The arrangement direction of the first regions m11 and the second regions m12 is the second direction F2. The middle region m121 is located at a middle position of the second region m12, and the edge regions m122 are distributed on two sides of the middle region m121 along the second direction F2.

It should be noted that the above-mentioned "middle region m121" and "edge regions m122" are regions into which the second region m12 is conceptually divided for ease of describing the technical solutions of the embodiments of the present application. Such division does not mean that the middle region m121 and the edge regions m122 are physically separated from or independent of each other. A boundary may or may not exist between the middle region m121 and the edge regions m122, and no particular limitation is imposed in this respect. Taking FIG. 6 as an example, a dashed line schematically indicates the boundary between the middle region m121 and the edge region m122 of the second region m12. The dashed line merely represents the division between the middle region m121 and the edge region m122 and is not intended to limit the structure of the second region m12. The view shown in FIG. 6 may be regarded as a top view corresponding to the view shown in FIG. 1.

Exemplarily, taking FIG. 1 as an example, the first direction F1, the second direction F2, and a third direction F3 intersect one another. For example, the second direction F2 and the third direction F3 may respectively be a length direction and a width direction of the back contact solar cell 100, and the first direction F1, the second direction F2, and the third direction F3 may be perpendicular to one another, without being specifically limited herein.

A thickness difference of a portion of the second passivation contact structure 130 located on the middle region m121 is greater than a thickness difference of portions of the second passivation contact structure 130 located on the edge regions m122.

The thickness of the second passivation contact structure 130 refers to a dimension measured, with the first surface m1 of the substrate 110 as a reference and in accordance with the undulations of the first surface m1, along a direction perpendicular to the first surface m1. It should be understood that, because the pyramid-shaped texture structure 1101 is provided on the second region m12 of the first surface m1, there are multiple directions perpendicular to the second region m12, and a particular perpendicular direction may be determined according to the shape of the corresponding portion. For example, the thickness of a portion of the second passivation contact structure 130 located on a side wall of the pyramid-shaped textured structure 1101 is a dimension of the portion along a direction perpendicular to the side wall of the pyramid-shaped textured structure 1101. As another example, taking FIG. 1 as an example, the thickness of a portion of the second passivation contact structure 130 located on a side of the first passivation contact structure 120 facing away from the substrate 110 is a dimension of the portion along the first direction F1.

A thickness difference of the second passivation contact structure 130 refers to a difference between a maximum thickness and a minimum thickness of the second passivation contact structure 130. A thickness difference of the second passivation contact structure 130 can be used to characterize a degree of thickness non-uniformity of the second passivation contact structure 130.

Exemplarily, in an actual measurement process, a cross-sectional sample of the back contact solar cell 100 may be prepared, and a portion of the back contact solar cell 100 including the second region m12 may be selected to obtain a corresponding SEM image. For example, first, the back contact solar cell 100 to be tested is cut along the first direction F1. Next, a sample of the portion of the back contact solar cell 100 including the second passivation contact structure 130 located on the second region m12 is obtained. The portion of the back contact solar cell 100 including the second region m12 may be determined based on, for example, an electrode disposed on the second region m12. Subsequently, a microscopic image showing a cross-sectional morphology of the second passivation contact structure 130 located on the second region m12 is obtained using a scanning electron microscope or the like. Then, in the microscopic image, with the first surface m1 of the substrate 110 as a lower boundary of the second passivation contact structure 130 and a surface of the second passivation contact structure 130 facing away from the substrate 110 as an upper boundary, the thickness of the second passivation contact structure 130 is measured using image analysis software. For example, a relatively thick region and a relatively thin region may be first preliminarily identified, and then 3, 5, 6, 8, 9, 10, 15, 20 or another number of measurement points are correspondingly selected in the relatively thick region and the relatively thin region. A maximum value and a minimum value are identified from the measurement data, and the thickness difference of the second passivation contact structure 130 can be calculated from the maximum value and the minimum value in the measurement data.

In some testing methods, measurement of the aforementioned thickness difference does not require the second passivation contact structures 130 on all of the second regions m12 to be individually tested; instead, sampling testing may be performed. A person skilled in the art may reasonably infer and determine, based on the thickness difference corresponding to a tested sample, the thickness differences of the second passivation contact structures 130 on other second regions m12. It should be understood that the design and layout of the passivation contact layer pattern exhibit regularity. For example, in the embodiments of the present application, the thickness differences of the second passivation contact structures 130 on other second regions m12 may be reasonably inferred and obtained by measuring the thickness differences of the second passivation contact structures 130 on one or more second regions m12.

Referring to FIG. 1 and FIG. 2 in conjunction, a portion of the second passivation contact structure 130 located on the middle region m121 is defined as a first portion 1301, which has a thickness d1; a portion of the second passivation contact structure 130 located on each of the edge regions m122 is defined as a second portion 1302, which has a thickness d2. That is, the thickness difference of the first portion 1301 is greater than the thickness difference of the second portion 1302. The thickness difference of the first portion 1301, the thickness difference of the second portion 1302, and the measurement methods thereof may be understood with reference to the thickness difference of the second passivation contact structure 130 and the measurement methods illustrated above. That the thickness difference of the first portion 1301 is greater than the thickness difference of the second portion 1302 means that, compared with the second portion 1302, the first portion 1301 has a higher degree of thickness non-uniformity and greater undulations.

The above-mentioned "first portion 1301" and "second portion 1302" are portions into which the second passivation contact structure 130 is conceptually divided for ease of describing the technical solutions of the embodiments of the present application. Such division does not mean that the first portion 1301 and the second portion 1302 are physically separated from or independent of each other.

Accordingly, by configuring the material of the second passivation contact structure 130 to include amorphous silicon and nanocrystalline silicon, the amorphous silicon can be utilized to improve the passivation effect of the second passivation contact structure 130, and the nanocrystalline silicon can be utilized to reduce a resistance of the second passivation contact structure 130, thereby reducing the contact resistance between the second passivation contact structure 130 and other conductive components. By configuring the thickness difference of the portion of the second passivation contact structure 130 located on the middle region m121 (i.e., the first portion 1301) to be greater than the thickness difference of the portions of the second passivation contact structure 130 located on the edge regions m122 (i.e., the second portion 1302), the locally thinner portion of the second passivation contact structure 130 increases the tunneling probability of carriers, while the locally thicker portion of the second passivation contact structure 130 provide a certain degree of passivation performance. Accordingly, the contact resistance can be reduced while a certain degree of passivation performance is maintained. In addition, the portions of the second passivation contact structure 130 located on the edge regions m122 may be utilized to improve the passivation effect at the edges or at interfaces with the first region m11, thereby reducing the risk of electrical leakage at edges and the recombination current and facilitating an increase in open-circuit voltage. Thus, through mutual cooperation of the amorphous silicon and the nanocrystalline silicon, and through mutual cooperation of the thickness difference of the portion of the second passivation contact structure 130 located on the middle region m121 and the thickness difference of the portions of the second passivation contact structure 130 located on the edge regions m122, the contact resistance between the second passivation contact structure 130 and other conductive components (such as transparent conductive layers or electrodes) can be reduced while passivation performance is improved, thereby improving the overall performance of the back contact solar cell 100.

It should be noted that configuring the material of the second passivation contact structure 130 to include amorphous silicon and nanocrystalline silicon improves the contact performance thereof, thereby allowing the thickness of the second passivation contact structure 130 to be increased and, in turn, enhancing its passivation capability. Since the second passivation contact structure 130 can be formed with an increased thickness, process tolerance may be further improved. Even if the second passivation contact structure 130 is locally damaged, its overall passivation capability may still be maintained and may even be better than the overall passivation capability achieved before the thickness of the second passivation contact structure 130 is increased.

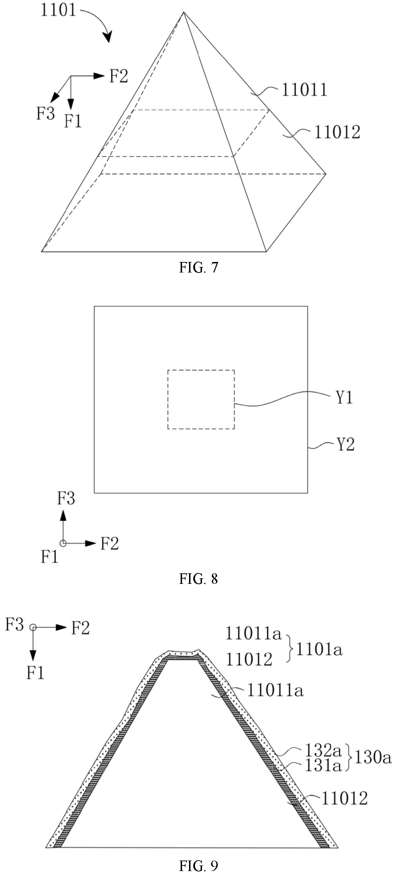

According to some embodiments of the present application, continuing to refer to FIGS. 1 and 3-5, and referring to FIG. 7 which is a schematic perspective structural view of the pyramid-shaped texture structure 1101 according to some embodiments of the present application, a material of a portion of the second passivation contact structure 130 located on a top region 11011 of the pyramid-shaped texture structure 1101 includes nanocrystalline silicon.

The pyramid-shaped texture structure 1101 comprises a top region 11011 and a base region 11012 connected to each other. The base region 11012 is located on the second region m12, and the top region 11011 is located on a side of the base region 11012 facing away from the second surface m2 of the substrate 110. In FIG. 7, a dashed line schematically indicates the boundary between the top region 11011 and the base region 11012, which is merely for distinguishing the top region 11011 from the base region 11012 and is not intended to limit the structure.

In this manner, because the nanocrystalline silicon is located on the top region 11011 of the pyramid-shaped texture structure 1101, it is beneficial to increase the contact area between the second passivation contact structure 130 and other conductive components, thereby further reducing transport loss of carriers between the second passivation contact structure 130 and other conductive components. Moreover, because an electrode first comes into contact with the second passivation contact structure 130 located on the top region 11011 of the pyramid-shaped texture structure 1101, when the nanocrystalline silicon is located on the top region 11011 of the pyramid-shaped texture structure 110, compressive stress and thermal stress generated during electrode manufacturing can be alleviated at the top region 11011 of the pyramid-shaped texture structure 1101. This not only facilitates the contact between the electrode and the second passivation contact structure 130, but also helps maintain the passivation effect of the second passivation contact structure 130.

Certainly, in some other embodiments, the materials of the portions of the second passivation contact structure 130 located on both the top region 11011 and the base region 11012 of the pyramid-shaped texture structure 1101 may include nanocrystalline silicon. Alternatively, the material of the portion of the second passivation contact structure 130 located on the top region 11011 of the pyramid-shaped texture structure 1101 may not include nanocrystalline silicon, while the material of the portion of the second passivation contact structure 130 located on the base region 11012 of the pyramid-shaped texture structure 1101 may include nanocrystalline silicon. No particular limitation is imposed in this respect.

It should be noted that, when the material of the portion of the second passivation contact structure 130 located on the base region 11012 of the pyramid-shaped texture structure 1101 dose not include nanocrystalline silicon, the portion of the second passivation contact structure 130 located on the base region 11012 of the pyramid-shaped texture structure 1101 can be utilized to relieve stress, thereby further improving the passivation effect. When the material of the portion of the second passivation contact structure 130 located on the base region 11012 of the pyramid-shaped texture structure 1101 includes nanocrystalline silicon, compressive stress and thermal stress can also be alleviated if the electrode comes into contact with the portion of the second passivation contact structure 130 located on the base region 11012 of the pyramid-shaped texture structure 1101, thereby further facilitating the contact between the electrode and the second passivation contact structure 130.

According to some embodiments of the present application, continuing to refer to FIG. 7, and referring to FIG. 8 which is a schematic projection view of the pyramid-shaped texture structure 1101 according to some embodiments of the present application, along a direction from the top region 11011 of the pyramid-shaped texture structure 1101 to the base region 11012 of the pyramid-shaped texture structure 1101, a projected area of the top region 11011 of the pyramid-shaped texture structure 1101 is defined as S1, and a projected area of the pyramid-shaped texture structure 1101 is defined as S2, where 0.01 ≤ S1/S2 ≤ 0.6.

The direction from the top region 11011 of the pyramid-shaped texture structure 1101 to the base region 11012 of the pyramid-shaped texture structure 1101 is parallel to the first direction F1. The projections of the top region 11011 of the pyramid-shaped texture structure 1101 and of the pyramid-shaped texture structure 1101 are defined by orthographic projections onto a base plane along a direction perpendicular thereto. The projections are a contour mapping onto a plane of the substrate 110 along the first direction F1. The projections are used merely to exemplarily show the positions of the corresponding morphological boundaries and does not result in enlargement, reduction, or deformation of the shape. It should be understood that, according to the orthographic projection rule in the embodiments of the present application, the projection is a positional mapping formed by perpendicularly projecting a spatial contour onto a base plane, in which the dimensions and contour proportions are equivalent to those of the original corresponding region, without scaling or distortion.

Exemplarily, referring to FIG. 8, which is a bottom view corresponding to the view shown in FIG. 1, along the first direction F1, the projection of the top region 11011 of the pyramid-shaped texture structure 1101 is defined as a projection Y1, and the projection of the pyramid-shaped texture structure 1101 is defined as a projection Y2. The area of projection Y1 is defined as S1, and the area of projection Y2 defined as is S2.

Exemplarily, the ratio S1/S2 may be 0.01, 0.06, 0.1, 0.13, 0.18, 0.22, 0.33, 0.35, 0.42, 0.48, 0.51, or 0.6. Certainly, the ratio S1/S2 may also be any value within a range defined by any two of the foregoing values, without being specifically limited herein.

Exemplarily, the ratio S1/S2 is in a range of 0.01 to 0.1. Certainly, the ratio S1/S2 may also fall within another range, such as 0.05 to 0.15, without being specifically limited herein.

By controlling the size of the top region 11011 of the pyramid-shaped texture structure 1101, that is, by controlling the distribution range of the nanocrystalline silicon located on the top region 11011 of the pyramid-shaped texture structure 1101, the contact resistance can be reduced while reducing the risk that an excessively large distribution range of the nanocrystalline silicon adversely affects the passivation effect of the second passivation contact structure 130.

It should be noted that the projected area of the top region 11011 of the pyramid-shaped texture structure 1101 and the projected area of the pyramid-shaped texture structure 1101 according to the embodiments of the present application may be measured by obtaining an image of a sample of the back contact solar cell 100 using a microscopic imaging instrument such as a scanning electron microscope or an atomic force microscope, and then obtaining values of the projected area of the top region 11011 of the pyramid-shaped texture structure 1101 and the projected area of the pyramid-shaped texture structure 1101 in the sample of the back contact solar cell 100 based on the image. The projected area of the top region 11011 of the pyramid-shaped texture structure 1101 and the projected area of the pyramid-shaped texture structure 1101 may be obtained based on a single pyramid-shaped texture structure 1101 or a plurality of pyramid-shaped texture structures 1101. When the projected areas are obtained based on a plurality of pyramid-shaped texture structures 1101, the projected area of the top region 11011 of the pyramid-shaped texture structure 1101 and the projected area of the pyramid-shaped texture structure 1101 may be average values.

For example, the projected area of the pyramid-shaped textured structure 1101 may be determined by imaging the pyramid-shaped textured structure 1101 in the first direction F1 using a scanning electron microscope to obtain a microscopic image thereof, identifying a boundary of the bottom surface of the pyramid-shaped textured structure 1101 in the microscopic image, and calculating, using image analysis software or another suitable tool, the area of a region enclosed by the boundary of the bottom surface of the pyramid-shaped textured structure 1101. The area of the enclosed region may be equal or approximately equal to the projected area of the pyramid-shaped textured structure 1101 in the first direction F1. As another example, a plurality of pyramid-shaped textured structures 1101 may be randomly selected from the microscopic image, the projected area of each of the plurality of pyramid-shaped textured structure 1101 may be measured, and an average value of the measured projected areas may be calculated and used as the average projected area of the pyramid-shaped textured structures 1101.

After the projected area of the pyramid-shaped texture structure 1101 is obtained, the projected area of the top region 11011 of the pyramid-shaped texture structure 1101 can be determined according to the ratio S1/S2 in the above range, such that the top region 11011 of the pyramid-shaped texture structure 1101 can also be identified. It should be understood that when the material of the portion of the second passivation contact structure 130 located on the top region 11011 of the pyramid-shaped texture structure 1101 includes nanocrystalline silicon, the nanocrystalline silicon can also be observed on the identified top region 11011 of the pyramid-shaped texture structure 1101.

According to some embodiments of the present application, 0.05 ≤ S1/S2 ≤ 0.15.

Exemplarily, referring to FIG. 8, the ratio of the area of the projection Y1 to the area of the projection Y2 may be 0.05, 0.07, 0.09, 0.11, 0.13, 0.14, or 0.15. Certainly, the ratio of the area of the projection Y1 to the area of the projection Y2 may also be any value within a range defined by any two of the foregoing values, without being specifically limited herein.

When 0.05 ≤ S1/S2 ≤ 0.15, the top region 11011 of the pyramid-shaped textured structure 1101 occupies a relatively smaller space than when 0.15 < S1/S2 ≤ 0.6, which is more conducive to improving the passivation effect of the second passivation contact structure 130, and the top region 11011 of the pyramid-shaped textured structure 1101 occupies a relatively larger space than when 0.01 ≤ S1/S2 < 0.05, which is more conducive to matching the electrode with the second passivation contact structure 130, thereby further improving the contact performance. By further controlling the size of the top region 11011 of the pyramid-shaped texture structure 1101, that is, by further controlling the distribution range of the nanocrystalline silicon located on the top region 11011 of the pyramid-shaped texture structure 1101, the contact resistance can be further reduced while reducing the risk that an excessively large distribution range of the nanocrystalline silicon adversely affects the passivation effect of the second passivation contact structure 130.

According to some embodiments of the present application, referring to FIG. 1 and FIG. 7, along the direction from the top region 11011 of the pyramid-shaped texture structure 1101 to the base region 11012 of the pyramid-shaped texture structure 1101, the crystallinity of the second passivation contact structure 130 decreases.

The crystallinity of the second passivation contact structure 130 refers to the volume percentage of the crystalline phase in the second passivation contact structure 130. Exemplarily, a decrease in crystallinity may mean that the crystal grains have a smaller size and/or that the number of crystal grains is reduced.

In this manner, the decrease in crystallinity, in conjunction with the variations in height of the pyramid-shaped texture structure 1101 along the first direction F1, can improve contact performance while maintaining passivation performance.

It should be noted that, in the embodiments of the present application, the crystallinity of the second passivation contact structure 130 can be observed based on the SEM image and the variations in the crystallinity can be obtained in conjunction with inferences based on the relevant process mechanisms. For example, with reference to the sampling process schematically illustrated above, after obtaining the microscopic image showing the cross-sectional morphology of the portion of the second passivation contact structure 130 located on the second region m12 and the cross-sectional morphology of the pyramid-shaped texture structure 1101 by the scanning electron microscope, the nanocrystalline silicon located on the pyramid-shaped texture structure 1101 can be observed at an enlarged magnification. In this way, it can be observed that the volume occupied by the nanocrystalline silicon located on a portion of the pyramid-shaped texture structure 1101 farther from the substrate 110 is greater than the volume occupied by the nanocrystalline silicon located on a portion of the pyramid-shaped texture structure 1101 closer to the substrate 110.

According to some embodiments of the present application, referring to FIG. 3 to FIG. 5, the grain size of the nanocrystalline silicon is defined as H, and 10 nm ≤ H ≤ 300 nm.

The nanocrystalline silicon grains may have various grain sizes; that is, the grain sizes of the nanocrystalline silicon grains may differ from one another and may be in a range of 10 nm to 300 nm.

Exemplarily, H may be 10 nm, 20 nm, 40 nm, 60 nm, 90 nm, 110 nm, 150 nm, 170 nm, 200 nm, 240 nm, 260 nm, 270 nm, or 300 nm. Certainly, H may also be any value within a range defined by any two of the foregoing values, without being specifically limited herein.

Exemplarily, one of the nanocrystalline silicon grains has a grain size of 10 nm, another one of the nanocrystalline silicon grains has a grain size of 20 nm, yet another one of the nanocrystalline silicon grains has a grain size of 50 nm, and still another one of the nanocrystalline silicon grains has a grain size of 100 nm, and so forth. Further examples are not exhaustively listed herein.

By controlling the grain size of the nanocrystalline silicon, the bandgap and interfacial stress of the second passivation contact structure 130 can be controlled, so that the second passivation contact structure 130 can exhibit a certain degree of electrical conductivity while reducing interfacial loading and the risk of the electrode penetration into the substrate 110, thereby achieving a balance between the passivation performance and the contact performance of the second passivation contact structure 130.

According to some embodiments of the present application, referring to FIG. 6, in the arrangement direction of the first regions m11 and the second regions m12, a dimension of the middle region m121 is defined as D1, a dimension of the second region m12 is defined as D2, and 0.5 ≤ D1/D2 ≤ 0.8.

Exemplarily, taking FIG. 6 as an example, the dimension of the middle region m121 in the arrangement direction of the first regions m11 and the second regions m12 is the dimension of the middle region m121 in the second direction F2, and the dimension of the middle region m121 in the second direction F2 can be regarded as the width of the middle region m121. Likewise, the dimension of the second region m12 in the arrangement direction of the first regions m11 and the second regions m12 is the dimension of the second region m12 in the second direction F2, and the dimension of the second region m12 in the second direction F2 can be regarded as the width of the second region m12. That is, the ratio of the width of the middle region m121 to the width of the second region m12 is in a range of 0.5 to 0.8.

Exemplarily, continuing with FIG. 6 as an example and referring to FIG. 1 in conjunction, because both the middle region m121 and the second region m12 extend in the third direction F3, both the middle region m121 and the second region m12 can be regarded as rectangular regions. The dimension of the middle region m121 in the third direction F3 can be regarded as the length of the middle region m121, and the dimension of the second region m12 in the third direction F3 can be regarded as the length of the second region m12. The length of the middle region m121 is substantially the same as the length of the second region m12. The ratio of the dimension D1 to the dimension D2 mentioned above can also be regarded as the ratio of the area of the middle region m121 to the area of the second region m12.

By controlling the dimension of the middle region m121, that is, by controlling the dimensions of the edge regions m122, the portions of the second passivation contact structure 130 with a larger thickness difference can be confined to a more appropriate distribution range, which not only facilitates the provision of the nanocrystalline silicon on the middle region m121 and the fabrication of an electrode corresponding to the middle region m121, thereby facilitating conductive contact, but also helps reduce the risk of leakage through isolation provided by the edge regions m122. In addition, in combination with the fact that the thickness difference of the portion of the second passivation contact structure 130 located on the middle region m121 is greater than the thickness difference of the portions of the second passivation contact structure 130 located on the edge regions m122, the edge regions m122 can serve as stress transition sections to relieve interfacial stress caused by the thickness difference of the second passivation contact structure 130, reducing the risk of cracking of the second passivation contact structure 130. Moreover, the controlled dimensions of the middle region m121 and the edge regions m122 can also buffer thickness fluctuations in forming the second passivation contact structure 130 and expand the process window.

According to some embodiments of the present application, referring to FIG. 1, FIG. 2, and FIG. 6, the thickness difference of the portion of the second passivation contact structure 130 located on the middle region m121 is defined as Δd1, the thickness difference of the portions of the second passivation contact structure 130 located on the edge regions m122 is defined as Δd2, and 2 nm ≤ Δd1 - Δd2 ≤ 20 nm.

Exemplarily, the difference between Δd1 and Δd2 may be 2 nm, 4 nm, 7 nm, 8 nm, 10 nm, 15 nm, 18 nm, or 20 nm. Certainly, the difference between Δd1 and Δd2 may also be any value within a range defined by any two of the foregoing values, without being specifically limited herein.

By controlling the difference between the thickness difference of the portion of the second passivation contact structure 130 located on the middle region m121 and the thickness difference of the portions of the second passivation contact structure 130 located on the edge regions m122, the undulation amplitudes of the portion of the second passivation contact structure 130 located on the middle region m121 and the portions of the second passivation contact structure 130 located on the edge regions m122 are relatively fixed, which not only facilitates the control of the crystallization state of the nanocrystalline silicon, but also allows a transition between the portion of the second passivation contact structure 130 located on the middle region m121 and the portions of the second passivation contact structure 130 located on the edge regions m122 to be smoother, reducing the risk of cracking caused by stress. In addition, such a control manner can not only regulate the electric leakage level at the boundaries and achieve a balance between the passivation performance and the contact performance, but also broaden the process window.

According to some embodiments of the present application, referring to FIG. 1, FIG. 2, and FIG. 6, the thickness difference of the portion of the second passivation contact structure 130 located on the middle region m121 is from 1 nm to 35 nm. That is, the thickness difference of the portion of the second passivation contact structure 130 located on the middle region m121 is ranged from 1 nm to 35 nm.

Exemplarily, the thickness difference of a section of the portion of the second passivation contact structure 130 located on the middle region m121 may be 1 nm, the thickness difference of another section of the portion of the second passivation contact structure 130 located on the middle region m121 may be 4 nm, the thickness difference of yet another section of the portion of the second passivation contact structure 130 located on the middle region m121 may be 20 nm, and the thickness difference of still another section of the portion of the second passivation contact structure 130 located on the middle region m121 may be 35 nm, without being specifically limited herein.

Controlling the range of the thickness difference of the portion of the second passivation contact structure 130 located on the middle region m121 is not only conducive to stabilizing the formation conditions of the nanocrystalline silicon on the middle region m121, but also conducive to controlling the stress and the passivation effect of the second passivation contact structure 130.

According to some embodiments of the present application, referring to FIG. 1, FIG. 2, and FIG. 6, the thickness difference of the portions of the second passivation contact structure 130 located on the edge regions m122 is from 1 nm to 30 nm.

Exemplarily, the thickness difference of a section of the portion of the second passivation contact structure 130 located on the edge region m122 may be 1 nm, the thickness difference of another section of the portion of the second passivation contact structure 130 located on the edge region m122 may be 4 nm, the thickness difference of yet another section of the portion of the second passivation contact structure 130 located on the edge region m122 may be 20 nm, and the thickness difference of still another section of the portion of the second passivation contact structure 130 located on the edge region m122 may be 30 nm, without being specifically limited herein.

Controlling the thickness difference of the portions of the second passivation contact structure 130 on the edge regions m122 not only can reduce the risk of electric leakage, but also can stabilize the passivation capability of the second passivation contact structure 130 at the edge regions m122.

According to some embodiments of the present application, referring to FIG. 1, FIG. 2, FIG. 6, and FIG. 7, a thickness difference of a portion of the second passivation contact structure 130 located on the middle region m121 and located on the top region 11011 of the pyramid-shaped texture structure 1101 is greater than the thickness difference of the portions of the second passivation contact structure 130 located on the edge regions m122.

Controlling the magnitudes of the above thickness differences not only facilitates formation of nanocrystalline silicon on the middle region m121 and on the top region 11011 of the pyramid-shaped texture structure 1101, enables the portion of the second passivation contact structure 130 contacting the electrode to exhibit an excellent electrical conductivity, thereby reducing the contact resistance, but also can reduce the risk of electrical leakage through the thickness difference of the portions of the second passivation contact structure 130 located on the edge regions m122. In addition, through such differentiated thickness difference control, a balance between the carrier collection efficiency and interface passivation effect can be achieved.

According to some embodiments of the present application, referring to FIG. 1 and FIG. 2, the second passivation contact structure 130 includes an amorphous material layer 131 and a first doped layer 132. The amorphous material layer 131 is disposed on the substrate 110, and the first doped layer 132 is disposed on a side of the amorphous material layer 131 facing away from the substrate 110.

The amorphous material layer 131 serves as a passivation and barrier functional layer, and is disposed at least on the second region m12 to achieve interface passivation. That the amorphous material layer 131 is disposed at least on the second region m12 means that the amorphous material layer 131 may be disposed entirely on the second region m12, or a portion of the amorphous material layer 131 may be disposed on the second region m12 while another portion of the amorphous material layer 131 may be disposed on the first region m11. Exemplarily, taking FIG. 1 as an example, it is schematically illustrated that a portion of the amorphous material layer 131 is disposed on the second region m12, and another portion of the amorphous material layer 131 is disposed on a side of the first passivation contact structure 120 facing away from the substrate 110. The amorphous material layer 131 may be a non-dielectric material layer. For example, the non-dielectric material includes amorphous silicon, microcrystalline silicon, or nanocrystalline silicon, etc. Exemplarily, the amorphous material layer 131 may be an intrinsic amorphous silicon layer, an intrinsic microcrystalline silicon layer, etc., without being specifically limited herein.

The first doped layer 132 contains a second doping element. Exemplarily, the first doping element is an N-type doping element, and the second doping element is a P-type doping element. For example, in the embodiments of the present application, the first doped layer 132 is formed by doping an amorphous silicon layer, a microcrystalline silicon layer, a polycrystalline silicon layer, or the like with a P-type doping element. Exemplarily, the first doped layer 132 is a boron-doped amorphous silicon layer.

Exemplarily, the amorphous material layer 131 may be an intrinsic amorphous silicon layer, and the first doped layer 132 may be a doped amorphous silicon layer. The intrinsic amorphous silicon layer has good surface passivation performance, and can reduce surface recombination at an interface between the first doped layer 132 and the substrate 110, thereby increasing the lifetime of charge carriers. In addition, the intrinsic amorphous silicon layer can also serve as a transport medium for both electrons and holes, promoting their separation and directional movement near the PN junction, and improving charge collection efficiency. When the first doped layer 132 is a P-type doped layer, the intrinsic amorphous silicon layer can serve as a barrier for electrons while allowing holes to pass therethrough. When the first doped layer 132 is an N-type doped layer, the intrinsic amorphous silicon layer can serve as a barrier for holes while allowing electrons to pass therethrough.

It should be noted that, taking the amorphous material layer 131 being an intrinsic amorphous material layer as an example, during the process of preparing the first doped layer 132, a small amount of the same doping element as that of the first doped layer 132 may diffuse or be incorporated into the amorphous material layer 131, such that the amorphous material layer 131 has a relatively low doping concentration. In this case, the amorphous material layer 131 is not an intrinsic amorphous material layer in the strict chemical sense, but rather a lightly doped amorphous material layer, which may also be referred to as a near-intrinsic amorphous material layer. In other words, the term "intrinsic" as used in the embodiments of the present application is a relative concept with respect to the second doped layer 122, rather than an absolute definition requiring the complete absence of doping. In the embodiments of the present application, the term "intrinsic" refers to a condition in which no intentional doping is performed, no doping is performed, or the actual amount of doping is extremely low (or very small), such that its effect on the conductivity type and conductivity performance is negligible. The term "intrinsic" encompasses an intrinsic amorphous material layer, a lightly doped amorphous material layer, and a near-intrinsic amorphous material layer.

In addition, when the amorphous material layer 131 is an intrinsic amorphous silicon layer and the material of the amorphous silicon layer includes nanocrystalline silicon, the amorphous silicon layer has a mixed phase of amorphous silicon and nanocrystalline silicon.

According to some embodiments of the present application, referring to FIG. 1, the first passivation contact structure 120 includes a tunneling layer 121 and a second doped layer 122. The tunneling layer 121 is disposed on the first region m11, and the second doped layer 122 is disposed on a side of the tunneling layer 121 facing away from the substrate 110.

The tunneling layer 121 is configured to provide interface passivation for the first region m11 of the first surface m1 of the substrate 110, reduce the interface-state density of the first region m11, and reduce carrier recombination at the first region m11, thereby providing a chemical passivation effect on the first region m11. Specifically, by saturating dangling bonds on the first region m11 of the first surface m1 of the substrate 110, the interface defect state density of the first region m11 of the first surface m1 of the substrate 110 is reduced, thereby reducing recombination centers in the first region m11 of the first surface m1 of the substrate 110 and thus reducing the carrier recombination rate. The tunneling layer 121 may be a dielectric material layer. For example, the tunneling layer 121 may be made of a material selected from at lease one of silicon oxide, magnesium fluoride, silicon oxide, amorphous silicon, polycrystalline silicon, silicon carbide, silicon nitride, silicon oxynitride, aluminum oxide, or titanium oxide. In the embodiments of the present application, the tunneling layer 121 may be formed by low pressure chemical vapor deposition (LPCVD). Certainly, the tunneling layer 121 may also be formed by other processes such as a thermal oxidation process, a plasma oxidation process, or a nitric acid oxidation process, without being specifically limited herein.

The conductivity type of the doping element in the second doped layer 122 is compatible with that of the doping element in the substrate 110. For example, when the substrate 110 is an N-type substrate 110, the doping element in the substrate 110 may be phosphorus and/or antimony, and the doping element in the second doped layer 122 may be phosphorus. As another example, when the substrate 110 is a P-type substrate 110, the doping element in the second doped layer 122 may be boron. In the embodiments of the present application, the second doped layer 122 is formed by doping an amorphous silicon layer, a microcrystalline silicon layer, a polycrystalline silicon layer, or the like with an N-type doping element. Exemplarily, the second doped layer 122 is a phosphorus-doped polycrystalline silicon layer. In this case, the tunneling layer 121 and the second doped layer 122 stacked with each other together form a passivation contact structure (i.e., the first passivation contact structure 120), and the passivation contact structure provides good surface passivation for the first region m11 of the first surface m1 of the substrate 110.

In some possible embodiments, taking FIG. 1 as an example, the substrate 110 may be an N-type doped substrate 110, the tunneling layer 121 may be made of silicon oxide (SiOₓ), the second doped layer 122 may be an N-type doped layer, the amorphous material layer 131 may be an intrinsic amorphous silicon layer, the amorphous silicon layer has a mixed phase of amorphous silicon and nanocrystalline silicon, and the first doped layer 132 may be a P-type doped layer. With such a configuration, the tunneling layer 121 is configured to allow electrons to pass therethrough, and the first doped layer 132 is configured to block electrons and allow holes to pass therethrough. Accordingly, by combining the high conductivity of the N-type polycrystalline silicon doped layer with the good passivation capability of the P-type amorphous silicon doped layer, the embodiments of the present application provide a balanced carrier transport and an improved photoelectric conversion efficiency of the back contact solar cell 100.

Certainly, in practical applications, the design of various film layers in the back contact solar cell 100 is not limited to the above-mentioned cases. For example, the substrate 110 may be a P-type doped substrate 110, the second doped layer 122 may be a P-type doped layer, and the first doped layer 132 may be an N-type doped layer. In this case, the tunneling layer 121 is configured to allow holes to pass therethrough, and the first doped layer 132 is configured to block holes and allow electrons to pass therethrough. No particular limitation is imposed in this respect.

According to some embodiments of the present application, referring to FIG. 1, FIG. 2, FIG. 6, and FIG. 7. A thickness difference of a portion of the amorphous material layer 131 located on the middle region m121 and located on the top region 11011 of the pyramid-shaped texture structure 1101 is greater than a thickness difference of portions of the amorphous material layer 131 located on the edge regions m122.

Because the portion of the amorphous material layer 131 located on the middle region m121 and located on the top region 11011 of the pyramid-shaped texture structure 1101 has a relatively large thickness difference, contact between the electrode and the second passivation contact structure 130 is facilitated, thereby improving the contact performance. Because the portions of the amorphous material layer 131 located on the edge regions m122 has a relatively small thickness difference, formation of a continuous passivation structure is facilitated and the risk of electrical leakage is reduced.

According to some embodiments of the present application, referring to FIG. 1, FIG. 2, FIG. 6, and FIG. 7, a thickness difference of a portion of the second passivation contact structure 130 located on the middle region m121 and on the base region 11012 of the pyramid-shaped texture structure 1101 is greater than the thickness difference of the portions of the second passivation contact structure 130 located on the edge regions m122.

Because the portion of the second passivation contact structure 130 located on the middle region m121 and on the base region 11012 of the pyramid-shaped texture structure 1101 has a relatively large thickness difference, its cooperation with the portion of the second passivation contact structure 130 located on the middle region m121 and on the top region 11011 of the pyramid-shaped texture structure 1101 in forming a buffer structure is facilitated, thereby dispersing the stress in the film layers. Because the portions of the second passivation contact structure 130 located on the edge regions m122 has a relatively small thickness difference, formation of a continuous passivation structure is facilitated and the risk of electrical leakage is reduced.

According to some embodiments of the present application, referring to FIG. 1, FIG. 2, FIG. 6, and FIG. 7, a thickness difference of a portion of the amorphous material layer 131 located on the middle region m121 and on the base region 11012 of the pyramid-shaped texture structure 1101 is greater than a thickness difference of portions of the amorphous material layer 131 located on the edge regions m122.

Because the portion of the amorphous material layer 131 located on the middle region m121 and on the base region 11012 of the pyramid-shaped texture structure 1101 has a relatively large thickness difference, its cooperation with the portion of the amorphous material layer 131 located on the middle region m121 and on the top region 11011 of the pyramid-shaped texture structure 1101 in forming a buffer structure is facilitated, thereby dispersing the stress in the film layers. Because the portions of the amorphous material layer 131 located on the edge regions m122 has a relatively small thickness difference, formation of a continuous passivation structure is facilitated and the risk of electrical leakage is reduced.

According to some embodiments of the present application, referring to FIG. 1, FIG. 2, FIG. 6, and FIG. 7, the thickness difference of the portion of the second passivation contact structure 130 located on the middle region m121 and on the top region 11011 of the pyramid-shaped texture structure 1101 is greater than the thickness difference of the portion of the second passivation contact structure 130 located on the middle region m121 and on the base region 11012 of the pyramid-shaped texture structure 1101.

In this manner, through a gradient morphology in which the thickness difference of the second passivation contact structure 130 decreases from the top region 11011 to the base region 11012, interfacial stress caused by abrupt thickness variations of the second passivation contact structure 130 on the same pyramid-shaped texture structure 1101 is alleviated. In addition, it is conductive to achieving a balance between the carrier extraction and the surface passivation effect on the same middle region m121.

According to some embodiments of the present application, referring to FIG. 1, FIG. 2, FIG. 6, and FIG. 7, the thickness difference of the portion of the amorphous material layer 131 located on the middle region m121 and on the top region 11011 of the pyramid-shaped texture structure 1101 is greater than the thickness difference of the portion of the amorphous material layer 131 located on the middle region m121 and on the base region 11012 of the pyramid-shaped texture structure 1101.

In this manner, it is not only conductive to forming nanocrystalline silicon, but also conductive to achieving a balance between the contact performance and the passivation performance.

According to some embodiments of the present application, referring to FIG. 1, FIG. 2, FIG. 6, and FIG. 7, the thickness difference of the portion of the amorphous material layer 131 located on the middle region m121 and on the top region 11011 of the pyramid-shaped texture structure 1101 is greater than the thickness difference of the portion of the amorphous material layer 131 located on the middle region m121 and on the base region 11012 of the pyramid-shaped texture structure 1101; and the thickness difference of the portion of the amorphous material layer 131 located on the middle region m121 and on the base region 11012 of the pyramid-shaped texture structure 1101 is greater than the thickness difference of the portions of the amorphous material layer 131 located on the edge regions m122.

In this manner, not only the advantages illustrated in some of the foregoing embodiments can be achieved, but also the alleviation of the interfacial stress caused by variations in film-layer morphology at different positions can be facilitated. In addition, the contact performance can be improved by the portion of the amorphous material layer 131 located on the middle region m121 and on the top region 11011 of the pyramid-shaped texture structure 1101, the buffering and passivation performances can be improved by the portion of the amorphous material layer 131 located on the middle region m121 and on the base region 11012 of the pyramid-shaped texture structure 1101, and the passivation performance can be improved and the risk of electrical leakage can be reduced by the portions of the amorphous material layer 131 located on the edge regions m122, thereby achieving a better balance between the passivation performance and the contact performance.

It should be noted that, referring to FIG. 9 in conjunction, which is a partial schematic structural view of a second passivation contact structure 130a in cooperation with a pyramid-shaped texture structure 1101a according to some embodiments of the present application, and illustrates a case in which the amorphous material layer 131a has a non-uniform thickness, the thickness of the first doped layer 132a is not limited.

In some other embodiments, the thickness of the first doped layer 132 may also be non-uniform, without being specifically limited herein. That is, the control of the thickness difference of the first doped layer 132 may also be implemented with reference to the control of the thickness difference of the amorphous material layer 131 as described above. For example, a thickness difference of a portion of the first doped layer 132 located on the middle region m121 and on the top region 11011 of the pyramid-shaped texture structure 1101 is greater than a thickness difference of a portion of the first doped layer 132 located on the middle region m121 and on the base region 11012 of the pyramid-shaped texture structure 1101. The thickness difference of a portion of the first doped layer 132 located on the middle region m121 and on the base region 11012 of the pyramid-shaped texture structure 1101 is greater than a thickness difference of portions of the first doped layer 132 located on the edge regions m122. In this manner, by controlling the thickness difference of the amorphous material layer 131 and the thickness difference of the first doped layer 132, the process window for manufacturing the second passivation contact structure 130 can be made larger, thereby further facilitating regulation of the passivation performance and the contact performance.

According to some embodiments of the present application, referring to FIG. 1, the back contact solar cell 100 further includes a first electrode 140. The first electrode 140 is disposed on a side of the second doped layer 122 facing away from the tunneling layer 121, and is electrically connected to the second doped layer 122.

The first electrode 140 is configured to collect and aggregate current generated by the back contact solar cell 100. The first electrode 140 and the second doped layer 122 may be in direct or indirect contact to form an electrical connection. Exemplarily, the first electrode 140 may be prepared by screen printing and sintering. Exemplarily, the metal paste for manufacturing the first electrode 140 may include a material selected from one or more of aluminum, silver, gold, nickel, molybdenum, or copper, without being specifically limited herein.

That the first electrode 140 is electrically connected to the second doped layer 122 means that, because the material of the first electrode 140 and the material of the second doped layer 122 are both conductive materials, direct or indirect physical contact between the first electrode 140 and the second doped layer 122 forms a physical channel through which photogenerated carriers may flow. When the back contact solar cell 100 is not in a power-generating or power-supplying state, the photogenerated carriers are not effectively separated and driven to flow and therefore do not flow through the physical channel. When the back contact solar cell 100 is in a power-generating or power-supplying state, photogenerated carriers are generated in the second doped layer 122 and separated under the action of the built-in electric field thereof, and the photogenerated carriers flow out through the physical channel.

According to some embodiments of the present application, referring to FIG. 1, the back contact solar cell 100 further comprises a first transparent conductive layer 150. The first transparent conductive layer 150 is disposed on a side of the second doped layer 122 facing away from the tunneling layer 121, and is electrically connected to the second doped layer 122. The first electrode 140 is located on the first transparent conductive layer 150.

Exemplarily, the first transparent conductive layer 150 may be made of a material selected from one or more of indium tin oxide (ITO), aluminum-doped zinc oxide (AZO), indium tungsten oxide (IWO), indium cerium oxide (ICO), or indium zinc oxide (IZO), without being specifically limited herein.

Provision of the first transparent conductive layer 150 is conducive to reducing transmission loss occurring when charge carriers are transported directly from the passivation contact structure to the electrode, thereby increasing the output power of the solar cell and improving the photoelectric conversion efficiency of the solar cell. Meanwhile, the first transparent conductive layer 150 may also improve the weather resistance of the solar cell and extend its service life.

According to some embodiments of the present application, referring to FIG. 1, the back contact solar cell 100 further comprises a second electrode 160. The second electrode 160 is disposed on a side of the first doped layer 132 facing away from the amorphous material layer 131, and is electrically connected to the first doped layer 132. The second electrode 160 may be understood and implemented with reference to the first electrode 140, and details are not described herein again.

According to some embodiments of the present application, referring to FIG. 1, the back contact solar cell 100 further comprises a second transparent conductive layer 170. The second transparent conductive layer 170 is disposed on a side of the first doped layer 132 facing away from the amorphous material layer 131, and is electrically connected to the first doped layer 132. The second electrode 160 is located on the second transparent conductive layer 170. The material and advantages of the second transparent conductive layer 170 may be understood and implemented with reference to the first transparent conductive layer 150, and details are not described herein again.

According to some embodiments of the present application, referring to FIG. 1, the back contact solar cell 100 further comprises a passivation anti-reflection layer 180. The passivation anti-reflection layer 180 is disposed on the second surface m2 of the substrate 110. The passivation anti-reflection layer 180 may have a single-layer structure or a multi-layer structure. In the passivation anti-reflection layer 180 having the multi-layer structure, each layer may be made of a material such as silicon oxide, silicon nitride, and silicon oxynitride. No particular limitation is imposed in this respect.

According to some embodiments of the present application, referring to FIG. 1, a pyramid-shaped structure is provided on the second surface m2. Accordingly, light utilization can be improved.

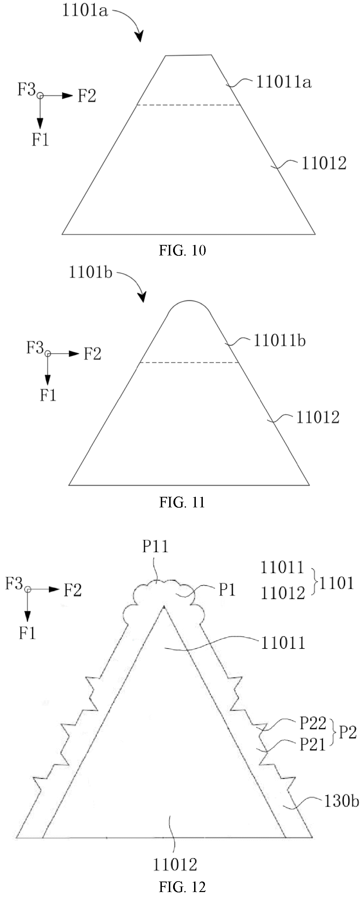

According to some embodiments of the present application, referring to FIG. 9 in conjunction with FIG. 10 which is a schematic view of a pyramid-shaped texture structure 1101a according to other embodiments of the present application, an end of the top region 11011a of the pyramid-shaped texture structure 1101a facing away from the base region 11012 of the pyramid-shaped texture structure 1101a has a platform-shaped structure.

The platform-shaped structure means that the top end of the pyramid-shaped texture structure 1101a is generally no longer a sharp point, and the top end surface of the pyramid-shaped texture structure 1101 may be or may be approximate to a flat platform surface.

In this manner, by configuring the end of the top region 11011a of the pyramid-shaped texture structure 1101a facing away from the base region 11012 of the pyramid-shaped texture structure 1101a to have a platform-shaped structure, it is not only conducive to improving the contact performance of the second passivation contact structure 130a with the electrode, but also conducive to controlling the thickness difference of the portion of the second passivation contact structure 130 on the top region 11011 of the pyramid-shaped texture structure 1101, thereby facilitating formation of nanocrystalline silicon.

According to some embodiments of the present application, referring to FIG. 11 which is a schematic view of a pyramid-shaped texture structure 1101b according to still other embodiments of the present application, an end of the top region 11011b of the pyramid-shaped texture structure 1101b facing away from the base region 11012b of the pyramid-shaped texture structure 1101b has a rounded shape.

The rounded shape means that the top end of the pyramid-shaped textured structure 1101b generally has no sharp corner, and that a side wall and a top surface of the top end smoothly transition into each other without an obvious angular transition point, such that the top end is generally smooth.

In this manner, by configuring the end of the top region 11011b of the pyramid-shaped texture structure 1101b facing away from the base region 11012b of the pyramid-shaped texture structure 1101b to have a smoothly rounded shape, not only the second passivation contact structure 130 at the top region 11011b can be protected and control of the thickness difference of the second passivation contact structure 130 can be facilitated, but also it is conducive to relieving the stress in the film layers and forming a continuously transitioning morphology, thereby facilitating a balance between the passivation performance and the contact performance.

It should be noted that, regardless of the particular shape of the pyramid-shaped texture structure, the overall shape thereof remains closer to a pyramid than a pedestal-like structure having a polished surface. In this manner, it is not only conducive to achieving a balance between the passivation performance and the contact performance, but also conducive to expanding the process window and reducing the process difficulty.

According to some embodiments of the present application, referring to FIG. 1, a reflectivity of the pyramid-shaped texture structure 1101 is from 5% to 20%.

Exemplarily, the reflectivity of the pyramid-shaped texture structure 1101 is from 8% to 16%.

Exemplarily, the reflectivity of the pyramid-shaped texture structure 1101 may be 5%, 8%, 10%, 15%, 16%, 18%, 19%, or 20%. Certainly, the reflectivity of the pyramid-shaped texture structure 1101 may be any other value within the range of 5% to 20%, or may be any other value within the range of 8% to 16%, without being specifically limited herein.

The reflectivity of the pyramid-shaped texture structure 1101 refers to an integrated average reflectivity of the pyramid-shaped texture structure 1101 over a primary operating wavelength range of 300 nm to 1200 nm. The reflectivity of the pyramid-shaped texture structure 1101 can be obtained by performing a reflectivity (REF) test using a quantum efficiency (QE) testing instrument or a D8 reflectivity testing instrument. For example, taking a QE testing instrument as an example, a QE curve over the wavelength range of 300 nm to 1200 nm may be obtained through measurement, and the reflectivity may be determined by performing weighted integration based on the QE curve. No particular limitation is imposed in this respect.

Exemplarily, the average reflectivity of the pyramid-shaped texture structure 1101 is from 10% to 16% over a wavelength range of 300 nm to 500 nm. For example, the average reflectivity of the pyramid-shaped texture structure 1101 may be 10%, 11%, 13%, 14%, 15%, or 16% over the wavelength range of 300 nm to 500 nm. Certainly, the average reflectivity of the pyramid-shaped texture structure 1101 may also be any other value within the range of 10% to 16% over the wavelength range of 300 nm to 500 nm, without being specifically limited herein.

Exemplarily, the average reflectivity of the pyramid-shaped texture structure 1101 is from 5% to 11% over a wavelength range of 500 nm to 900 nm. For example, the average reflectivity of the pyramid-shaped texture structure 1101 may be 5%, 7%, 8%, 10%, or 11% over the wavelength range of 500 nm to 900 nm. Certainly, the average reflectivity of the pyramid-shaped texture structure 1101 may also be any other value within the range of 5% to 11% over the wavelength range of 500 nm to 900 nm, without being specifically limited herein.

Exemplarily, the average reflectivity of the pyramid-shaped texture structure 1101 is from 13% to 19% over a wavelength range of 900 nm to 1200 nm. For example, the average reflectivity of the pyramid-shaped texture structure 1101 may be 13%, 15%, 16%, 17%, or 19% over a wavelength range of 900 nm to 1200 nm. Certainly, the average reflectivity of the pyramid-shaped texture structure 1101 may also be any other value within the range of 13% to 19% over a wavelength range of 900 nm to 1200 nm, without being specifically limited herein.

The average reflectivity of the pyramid-shaped texture structure 1101 over the wavelength range of 300 nm to 500 nm, over the wavelength range of 500 nm to 900 nm, or over the wavelength range of 900 nm to 1200 nm can also be obtained by the above-mentioned measurement method for the reflectivity of the pyramid-shaped texture structure 1101. The difference is that the wavelength ranges set during the measurement are different.

By controlling the reflectivity of the pyramid-shaped texture structure 1101, most of the laser energy can be absorbed, and only a small portion of the laser is lost through reflection, such that the intensity and energy distribution of the laser light incident on the second passivation contact structure 130 can be altered. In combination with the concave-convex morphology of the pyramid-shaped texture structure 1101, it is conducive to controlling the formation of nanocrystalline silicon by laser. In addition, the process windows for parameters such as laser wavelength, laser power, and spot overlap ratio may be broadened, thereby further facilitating control over the formation of nanocrystalline silicon having different sizes at different positions while suppressing damage. In this manner, a balance between the passivation performance and the contact performance may be further improved.

According to some embodiments of the present application, referring to FIG. 12 which is a partial schematic structural view of a second passivation contact structure 130b in cooperation with a pyramid-shaped texture structure 1101 according to other embodiments of the present application, the second passivation contact structure 130b includes a first conductive portion P1 and a second conductive portion P2. The first conductive portion P1 is located at an end of the top region 11011 of the pyramid-shaped texture structure 1101 facing away from the base region 11012 of the pyramid-shaped texture structure 1101. The second conductive portion P2 is located on a side wall of the pyramid-shaped texture structure 1101. That is, the second conductive portion P2 may be located at a middle portion and a bottom portion of the pyramid-shaped texture structure 1101. In other words, the second conductive portion P2 covers a region of the pyramid-shaped texture structure 1101 not covered by the first conductive portion P1.

The first conductive portion P1 and the second conductive portion P2 have different morphologies in their respective portions protruding relative to the pyramid-shaped textured structure 1101.

In this manner, because the morphology of the first conductive portion P1 differs from that of the second conductive portion P2, the morphological difference can facilitate formation, in the second passivation contact structure 130b, of regions having different crystallinities, thereby facilitating a balance between the contact resistance and the passivation performance.

According to some embodiments of the present application, referring to FIG. 12, the first conductive portion P1 is formed with a plurality of protrusions P11 extending in a direction away from the pyramid-shaped texture structure 1101. Each protrusion P11 has an arcuate cross-sectional contour.

By controlling the shape of the first conductive portion P1, not only its contact with the electrode is facilitated, but also the difficulty of manufacturing subsequent film layers is reduced and the stress is dispersed. Moreover, the arcuate curved surfaces provide more uniform diffuse reflection of laser light, thereby facilitating concentration of heat in the region of the first conductive portion P1, which, in turn, facilitates formation, in the first conductive portion P1, of nanocrystalline silicon having a desired crystallinity and a controllable grain size.

According to some embodiments of the present application, referring to FIG. 12, the second conductive portion P2 includes a base portion P21 and a tapered portion P22 disposed on a side of the base portion P21 facing away from the side wall of the pyramid-shaped texture structure 1101.

By controlling the shape of the second conductive portion P2, the base portion P21 can be utilized to improve adhesion stability, and the tapered portion P22, which dissipates heat more rapidly, can be utilized to reduce the risk of large-area overheating-induced crystallization on the side wall region of the pyramid-shaped texture structure 1101, thereby facilitating improvement in the passivation performance of the second passivation contact structure 130.

Certainly, when the shapes of both the first conductive portion P1 and the second conductive portion P2 are controlled, the different degrees of laser reflection provided by the conductive portions having the two different shapes can cause the portion of the second passivation contact structure 130 located on the top region 11011 of the pyramid-shaped textured structure 1101 to have a higher crystallinity and the portion of the second passivation contact structure 130 located on the base region 11012 of the pyramid-shaped textured structure 1101 to have a lower crystallinity. Accordingly, not only a balance between the passivation performance and the contact performance be facilitated, but also the laser-process defects can be reduced and the process stability can be improved.

It should be noted that the above-mentioned first conductive portion P1 and second conductive portion P2 may be manufactured by combining a wet etching process with a mask or the like, or may be manufactured by a laser process.

The embodiments of the present application further provide a method for manufacturing the back contact solar cell according to any one of the above embodiments, including:

step S110: providing a back contact solar cell intermediate, wherein the back contact solar cell intermediate includes a substrate, a first passivation contact structure, and an initial second passivation contact structure.

step S120: processing a middle region of a second region of the substrate by a laser process, so as to form nanocrystalline silicon in the initial second passivation contact structure, and to cause a thickness difference of a portion of the initial second passivation contact structure located on the middle region to be greater than a thickness difference of a portion of the initial second passivation contact structure located on an edge region, thereby forming a second passivation contact structure.

Through the processing by laser, the degree of crystallinity of the second passivation contact structure can be changed, thereby facilitating reducing the resistance of the second passivation contact structure, so as to reduce the contact resistance between the second passivation contact structure and other conductive components (e.g., a transparent conductive layer or an electrode), thereby facilitating reducing transport loss of carriers collected in the second passivation contact structure. Since the laser is applied to the middle region of the second region of the substrate, the risk of damage to the edge region can also be reduced. In addition, the back contact solar cell manufactured by the manufacturing method may also provide the other advantages of the back contact solar cells illustrated in the foregoing embodiments, which will not be repeated herein.

Furthermore, the control of the various thickness differences illustrated above, as well as the first conductive portion and the second conductive portion, can be obtained by the laser process. The crystallinity of different portions of the second passivation contact structure can be changed by the laser processing. The portion irradiated by the laser would be heated to a molten state. After the laser irradiation is stopped, a corresponding morphology can be obtained. For example, one or more recessed structures may be formed when the laser energy is relatively small; and a tapered structure may be formed by controlling the recessed morphology when the laser energy is relatively large. These morphologies can be observed in images of the back contact solar cell sample obtained by microscopic instruments such as a scanning electron microscope or an atomic force microscope (AFM).

Because the laser energy distribution is generally non-uniform, different regions of the second passivation contact structure irradiated by the laser may receive different amounts of energy, such that regions in which nanocrystalline silicon is formed may exhibit a mixed-phase state. In conjunction with the foregoing control of the reflectivity of the pyramid-shaped textured structure, the laser energy can be redistributed, thereby facilitating formation of the desired morphology.

According to some embodiments of the present application, parameters of the laser process satisfy at least one of the following conditions: the laser is a green nanosecond laser; an energy density of each laser spot is from 20 mJ/cm² to 200 mJ/cm²; adjacent laser spots are arranged tangentially to each other or in an overlapping manner.

Adjacent laser spots being arranged in an overlapping manner means that an overlap ratio may be present between the laser spots. The overlap ratio between spots refers to a ratio of a dimension of an overlapping portion between adjacent laser spots (or between adjacent laser scanning paths) to a dimension of a single laser spot. For example, the overlap ratio between spots may be 30%, 40%, 50%, 70%, or 90%, without being specifically limited herein. Adjacent laser spots being arranged tangentially to each other means that adjacent laser spots (or adjacent laser scanning paths) do not overlap but adjoin each other.

Exemplarily, the laser may scan the middle region m121 along the third direction F3 illustrated above.

Exemplarily, the energy density of the laser spot may be 20 mJ/cm², 30 mJ/cm², 50 mJ/cm², 80 mJ/cm², 100 mJ/cm², 120 mJ/cm², 130 mJ/cm², 170 mJ/cm², or 200 mJ/cm². Certainly, the energy density of the laser spot may be any other value within the range of 20 mJ/cm² to 200 mJ/cm², without being specifically limited herein.

In this manner, by controlling the parameters of the laser process, it is conducive to inhibiting diffusion of the second doping element into the amorphous material layer in the second passivation contact structure, thereby facilitating improvement in passivation.

In some embodiments, the back contact solar cell illustrated above may be used in a tandem solar cell. For example, the tandem solar cell includes the back contact solar cell and a perovskite top cell, and the perovskite top cell is electrically connected to the back contact solar cell.

By combining the above-mentioned back contact solar cell with the perovskite top cell to form the tandem solar cell, solar radiation over a broader spectral range may be absorbed, thereby improving the photoelectric conversion efficiency of the tandem solar cell. Because the back contact solar cell provides the technical effects described above, the tandem solar cell including the back contact solar cell may likewise provide such technical effects, which will not be repeated herein.

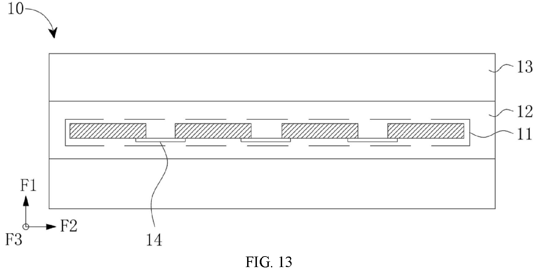

Referring to FIG. 13 which is a schematic structural view of a photovoltaic module 10 according to some embodiments of the present application, embodiments of the present application provide a photovoltaic module 10, including: the back contact solar cell according to any one of the above embodiments; or the back contact solar cell manufactured by a method for manufacturing a back contact solar cell according to any one of the above embodiments.

Further, the back contact solar cells 100 are electrically connected in the form of full-size cells or cells divided into a plurality of cell pieces to form a plurality of cell strings 11. The cell strings 11 are electrically connected in series and/or in parallel.

In some embodiments, the photovoltaic module 10 further includes an encapsulation layer 12 and a cover plate 13. The encapsulation layer 12 is configured to cover a surface of the cell strings 11, and the cover plate 13 is configured to cover a surface of the encapsulation layer 12 facing away from the cell strings 11.

In some embodiments, the cell strings 11 may be electrically connected via conductive ribbons 14. The encapsulation layer 12 covers both a front side and a back side of the back contact solar cells.

In some embodiments, the encapsulation layer 12 may be an organic encapsulation adhesive film such as an ethylene-vinyl acetate copolymer (EVA) adhesive film, a polyethylene-octene elastomer (POE) adhesive film, or a polyethylene terephthalate (PET) adhesive film.

In some embodiments, the cover plate 13 may be a glass cover plate, a plastic cover plate, or other cover plate having a light-transmitting function.

In some embodiments, a surface of the cover plate 13 facing the encapsulation layer 12 may be an uneven surface, so as to increase utilization of incident light.

The photovoltaic module 10 may likewise provide the foregoing advantages of the back contact solar cell, which will not be repeated herein.

## Claims

1. A back contact solar cell, comprising:
a substrate having a first surface, the first surface comprising a first region and a second region arranged alternately, and the second region being provided with a pyramid-shaped texture structure;
a first passivation contact structure disposed on the first region; and
a second passivation contact structure disposed at least on the second region and covering the pyramid-shaped texture structure, the second passivation contact structure comprising amorphous silicon and nanocrystalline silicon;
wherein the second region comprises a middle region and edge regions located on two sides of the middle region in an arrangement direction of the first region and the second region; a thickness difference of a portion of the second passivation contact structure located on the middle region is greater than a thickness difference of portions of the second passivation contact structure located on the edge regions.

2. The back contact solar cell according to claim 1, wherein a portion of the second passivation contact structure located on a top region of the pyramid-shaped texture structure comprises nanocrystalline silicon.

3. The back contact solar cell according to claim 1 or claim 2, wherein in a direction from the top region of the pyramid-shaped texture structure to a base region of the pyramid-shaped texture structure, a projected area of the top region of the pyramid-shaped texture structure is S1, a projected area of the pyramid-shaped texture structure is S2, and 0.01 ≤ S1/S2 ≤ 0.6;
optionally, 0.05 ≤ S1/S2 ≤ 0.15.

4. The back contact solar cell according to any one of claims 1 to 3, wherein in a direction from a top region of the pyramid-shaped texture structure to a base region of the pyramid-shaped texture structure, a crystallinity of the second passivation contact structure decreases; and/or
a grain size of nanocrystalline silicon is H, and 10 nm ≤ H ≤ 300 nm.

5. The back contact solar cell according to any one of claims 1-4, wherein in the arrangement direction of the first region and the second region, a dimension of the middle region is D1, a dimension of the second region is D2, and 0.5 ≤ D1/D2 ≤ 0.9; and/or
the thickness difference of the portion of the second passivation contact structure located on the middle region is Δd1, the thickness difference of the portions of the second passivation contact structure located on the edge regions is Δd2, and 2 nm ≤ Δd1 - Δd2 ≤ 20 nm;
optionally, the thickness difference of the portion of the second passivation contact structure located on the middle region is from 1 nm to 35 nm.

6. The back contact solar cell according to any one of claims 1-5, wherein a thickness difference of a portion of the second passivation contact structure located on the middle region and on a top region of the pyramid-shaped texture structure is greater than the thickness difference of the portions of the second passivation contact structure located on the edge regions.

7. The back contact solar cell according to claim 6, wherein the second passivation contact structure comprises an amorphous material layer and a first doped layer, the amorphous material layer is disposed on the substrate, and the first doped layer is disposed on a side of the amorphous material layer facing away from the substrate; and
a thickness difference of a portion of the amorphous material layer located on the middle region and on the top region of the pyramid-shaped texture structure is greater than a thickness difference of portions of the amorphous material layer located on the edge regions.

8. The back contact solar cell according to any one of claims 1-7, wherein a thickness difference of a portion of the second passivation contact structure located on the middle region and on a base region of the pyramid-shaped texture structure is greater than the thickness difference of the portions of the second passivation contact structure located on the edge regions.

9. The back contact solar cell according to claim 8, wherein the second passivation contact structure comprises an amorphous material layer and a first doped layer, the amorphous material layer is disposed on the substrate, and the first doped layer is disposed on a side of the amorphous material layer facing away from the substrate; and
a thickness difference of a portion of the amorphous material layer located on the middle region and on the base region of the pyramid-shaped texture structure is greater than a thickness difference of portions of the amorphous material layer located on the edge regions.

10. The back contact solar cell according to any one of claims 1-9, wherein a thickness difference of a portion of the second passivation contact structure located on the middle region and on a top region of the pyramid-shaped texture structure is greater than a thickness difference of a portion of the second passivation contact structure located on the middle region and on a base region of the pyramid-shaped texture structure.

11. The back contact solar cell according to claim 10, wherein the second passivation contact structure comprises an amorphous material layer and a first doped layer, the amorphous material layer is disposed on the substrate, and the first doped layer is disposed on a side of the amorphous material layer facing away from the substrate; and
a thickness difference of a portion of the amorphous material layer located on the middle region and on the top region of the pyramid-shaped texture structure is greater than a thickness difference of a portion of the amorphous material layer located on the middle region and on the base region of the pyramid-shaped texture structure.

12. The back contact solar cell according to any one of claims 1-11, wherein an end of the top region of the pyramid-shaped texture structure facing away from a base region of the pyramid-shaped texture structure has a rounded shape or a platform-shaped structure.

13. A method for manufacturing the back contact solar cell according to any one of claims 1-12, comprising:
providing a back contact solar cell intermediate, the back contact solar cell intermediate comprising the substrate, the first passivation contact structure, and an initial second passivation contact structure; and
processing the middle region of the second region of the substrate by a laser process, so as to form nanocrystalline silicon in the initial second passivation contact structure, and to cause a thickness difference of a portion the initial second passivation contact structure located on the middle region to be greater than a thickness difference of portions of the initial second passivation contact structure located on the edge regions, thereby forming the second passivation contact structure.

14. The method according to claim 13, wherein parameters of the laser process satisfy at least one of the following conditions:
the laser is a green nanosecond laser;
an energy density of a laser spot is from 20 mJ/cm² to 200 mJ/cm²;
adjacent laser spots are arranged tangentially to each other or in an overlapping manner.

15. A photovoltaic module, comprising: the back contact solar cell according to any one of claims 1-12; or the back contact solar cell manufactured by the method according to claim 13 or 14.
